# EUROPÄISCHE PATENTSCHRIFT

(11) **EP 1 631 728 B1**
(45) Veröffentlichungstag und Bekanntmachung des Hinweises auf die Patenterteilung: **13.08.2008**
(21) Anmeldenummer: 04739449.9
(22) Anmeldetag: 28.05.2004
(51) Int. Cl.: E04B 9/06

(54) **PROFILSCHIENE UND VERFAHREN ZUM HERSTELLEN EINER PROFILSCHIENE**
PROFILED RAIL AND METHOD FOR PRODUCING A PROFILED RAIL
RAIL PROFILE ET PROCEDE DE REALISATION D'UN RAIL PROFILE

(30) Priorität: 11.06.2003 DE 10326333
(43) Veröffentlichungstag der Anmeldung: 08.03.2006
(73) Patentinhaber: Protektorwerk Florenz Maisch GmbH & Co. KG, 76571 Gaggenau (DE)
(72) Erfinder: MAISCH, Christof, 76571 Gaggenau (DE); HERTWECK, Theo, 76532 Baden-Baden (DE); WILLERSCHEID, Heiner, 77886 Lauf (DE)
(74) Vertreter: Manitz, Gerhart
(86) Internationale Anmeldenummer: PCT/EP2004/005825
(87) Internationale Veröffentlichungsnummer: WO 2004/109030

(56) Entgegenhaltungen:
- WO-A-97/06321
- US-A- 1 984 028
- US-A- 3 807 111

## Beschreibung

Die vorliegende Erfindung betrifft eine Profilschiene zum Tragen von plattenförmigen Elementen, insbesondere für die Einlegemontage von Deckenplatten für Rasterdecken, mit einem zumindest bereichsweise als T-Profil ausgebildeten Grundkörper, der einen lang gestreckten Steg sowie einen Untergurt umfasst, der entlang einer Längskante des Steges angeordnet ist und zwei sich jeweils von dem Steg im Wesentlichen in entgegengesetzte Richtungen erstreckende Untergurtabschnitte umfasst, wobei der Untergurt durch eine Abwinklung des Steges gebildet und die von dem Steg abgewandt gelegene Seite des Untergurts mit einer Sichtblende versehen ist und wobei in dem Steg eine Vielzahl von Öffnungen ausgebildet ist. Weiterhin ist die Erfindung auf ein Verfahren zum Herstellen einer solchen Profilschiene gerichtet.

Profilschienen der eingangs genannten Art werden beispielsweise bei der Montage von Rasterdecken verwendet. US-A-3807 111 offenbart eine Profilschiene nach dem Oberbegriff des Anspruchs 1. Für die Montage der Rasterdecken werden zunächst eine Vielzahl von Profilschienen in Längsrichtung hintereinander sowie im rechten Winkel dazu an der Decke abgehängt, so dass eine Rahmenkonstruktion geschaffen wird, die aneinander angrenzende, rechteckige Bereiche aufweist, in welche Deckenplatten eingelegt werden können. Die Platten werden zunächst in die Bereiche zwischen die voneinander beabstandeten Profilschienen schräg eingeführt und anschließend auf die Innenseiten der Untergurte der T-Profilschienen abgelegt. Zusätzlich werden die Platten üblicherweise noch gegen ein Abheben nach Oben gesichert.

Die Rahmenkonstruktion besteht aus parallel verlaufenden T-Hauptprofilschienen, zwischen welchen T-Querprofilschienen angeordnet sind, die sich senkrecht zu den T-Hauptprofilschienen erstrecken. Die Hauptprofile und die Querprofile sind dabei üblicherweise identisch aufgebaut.

Bekannte Profilschienen sind beispielsweise aus einem Blechstreifen hergestellt, welcher zunächst zur Bildung des Steges entlang seiner Mittenlängsachse um 180° umgefaltet ist, so dass jeweils die beiden Hälften des Blechstreifens flächig aneinander anliegen. Die beiden freien Enden des umgebogenen Blechstreifens sind jeweils nochmals um 90° nach außen umgefaltet, so dass sie die beiden Untergurtabschnitte des Untergurts der auf diese Weise hergestellten T-Profilschiene bilden.

An der dem Untergurt entgegengesetzten Längskante des Profils ist üblicherweise ein Obergurt vorgesehen, der beispielsweise als Hohlprofil ausgebildet sein kann. Über diesen Obergurt ist eine Ankopplung von Befestigungselementen möglich, über die die Profilschienen an der Decke abgehängt werden können.

An der Unterseite des Untergurts ist üblicherweise eine Sichtblende vorgesehen, durch die ein sauberer optischer Abschluss der Profilschiene nach unten erreicht wird.

Problematisch an den Profilschienen dieser Art ist es, dass durch den symmetrischen Aufbau der Steg doppelwandig, d. h. mit doppelter Materialstärke ausgebildet ist, was hinsichtlich des erforderlichen Materialaufwands nachteilig ist. Da bei Profilschienen das erforderliche Material einen erheblichen Anteil an den Herstellungskosten besitzt, ist eine Reduzierung des erforderlichen Materialaufwands wünschenswert.

Weiterhin sind in den Profilschienen der eingangs genannten Art üblicherweise in regelmäßigen Abständen Durchbrechungen in dem Steg vorgesehen, welche eine Art Sollknickstellen für den Brandfall bilden. Da sich die Profilschienen im Brandfall aufgrund der hohen Hitzeentwicklung relativ stark ausdehnen, würde ohne entsprechende Vorkehrungen durch diese Längsausdehnungen die Deckenaufhängungen relativ schnell abreißen, so dass die Gefahr besteht, dass die gesamte Deckenkonstruktion im Brandfall abstürzt.

Durch die Durchbrechungen werden Sollknickstellen geschaffen, so dass bei starken Ausdehnungen aufgrund von großer Hitzeentwicklung durch die bei der Ausdehnung auftretenden Kräfte die Profilschienen-an den Sollknickstellen abknicken, wodurch ein Abreißen der Aufhängungen verhindert wird.

Ist der vorgesehene Obergurt als Hohlprofil ausgebildet, so sind hier üblicherweise entsprechende Quetschungen des Hohlprofils vorgesehen, um die erforderlichen Sollknickstellen zu erzeugen:

Die Erzeugung der Sollknickstellen in Form von zusätzlichen Durchbrechungen bzw. Quetschungen ist mit zusätzlichen Kosten verbunden.

Es ist eine Aufgabe der vorliegenden Erfindung, eine Profilschiene der eingangs genannten Art so auszubilden, dass der für die Herstellung erforderliche Materialaufwand verringert werden kann.

Diese Aufgabe wird erfindungsgemäß ausgehend von einer Profilschiene der eingangs genannten Art dadurch gelöst, dass zumindest einer der Untergurtabschnitte durch aus den Öffnungen heraus geklappte Materialabschnitte des Steges gebildet ist und dass der Steg im Wesentlichen über seine gesamte Fläche einlagig ausgebildet ist. Ein erfindungsgemäßes Verfahren zum Herstellen einer Profilschiene zum Tragen von plattenförmigen Elementen, insbesondere für die Einlegemontage von Deckenplatten für Rasterdecken, ist dadurch gekennzeichnet, dass ein lang gestreckter Materialstreifen, insbesondere ein Metall- oder Blechstreifen, mit einer Vielzahl von länglichen Einschnitten versehen wird, wobei die beiden freien Enden der Einschnitte jeweils auf einer im Wesentlichen parallel zur Längsachse des Materialstreifens verlaufenden, eine Biegelinie bildenden Geraden angeordnet sind, und dadurch, dass der Materialstreifen entlang dieser Biegelinie umgebogen wird.

Erfindungsgemäß wird somit durch eine bestimmte Schnitt- und Falttechnik der Materialaufwand für die Herstellung von Profilschienen der eingangs genannten Art deutlich verringert. Der Steg besitzt auf diese Weise nur eine einlagige Ausbildung, so dass dadurch der Materialbedarf im Gegensatz zu herkömmlichen Profilschienen deutlich reduziert wird. Die Einschnitte können insbesondere U-förmig ausgebildet sein, wobei der Materialstreifen entlang der Biegelinie in eine einheitliche Richtung umgebogen wird, wodurch die erwähnten, von den Einschnitten-begrenzten Öffnungen entstehen. Einer der Untergurtabschnitte ist dabei durch eine Vielzahl von aus den Öffnungen heraus geklappten Materialabschnitten des Steges und der andere Untergurtabschnitt ist im Wesentlichen durch eine einstückige Abwinklung des Steges gebildet.

Grundsätzlich ist es auch möglich, dass die Biegerichtung über Teilbereiche des Materialstreifens alternierend wechselt, so dass über aufeinander folgende Teilbereiche des Materialstreifens jeder der Untergurtabschnitte teilweise aus mehreren aus den Öffnungen heraus geklappten Materialabschnitten und teilweise aus einem jeweils einstückig ausgebildeten Bereich des Materialabschnitts gebildet ist, der durch den jeweiligen Biegevorgang in die entgegengesetzte Richtung gebogen wird. Dazu können in dem umzuklappenden Bereich des Materialabschnitts zwischen den Teilbereichen jeweils Einschnitte oder Ausnehmungen vorgesehen sein, die ein alternierendes Umklappen der Teilbereiche ermöglichen und sich insbesondere von einer Längskante des Materialabschnitts bis zu der Biegelinie hin erstrecken.

Dadurch, dass das ursprünglich in den Stegöffnungen angeordnete Material bei einem Stanz- oder Schneidvorgang nicht entfernt wird, sondern unmittelbar zur Bildung zumindest eines der Untergurtabschnitte verwendet wird, können in einem einzigen Arbeitsschritt sowohl der Untergurt sowie die für die Sollknickstellen erforderlichen Öffnungen erzeugt werden. Gleichzeitig wird das aus den Öffnungen heraus geklappte Material des Stegs nicht verschwendet, sondern unmittelbar zur Bildung des Untergurts verwendet; wodurch eine deutliche Materialeinsparung erzielt wird.

Da der Untergurtabschnitt, der in üblicher Weise durch die direkte Abwinklung des Steges gebildet wird, bei der beschriebenen bevorzugten Ausführungsform weiterhin in Längsrichtung unterbrechungsfrei ausgebildet ist und an der Unterseite des Untergurts eine Sichtblende vorgesehen ist, ist eine ausreichende Längsstabilität sowie der gleiche optisch einwandfreie Abschluss der erfindungsgemäßen Profilschiene nach unten gewährleistet, wie bei herkömmlichen Profilschienen.

Nach einer weiteren vorteilhaften Ausführungsform der Erfindung besitzen die Öffnungen jeweils eine gerade Kante, die im Wesentlichen parallel zu einer Längskante des Stegs verläuft. Dadurch wird erreicht, dass die aus den Öffnungen heraus geklappten Materialabschnitte parallel zum Steg verlaufende Außenkanten besitzen. Insbesondere ist es vorteilhaft, wenn die außen liegenden Längskanten der beiden Untergurtabschnitte im Wesentlichen parallel zueinander verlaufen. Auf diese Weise wird eine den üblichen Profilschienen entsprechende Form der erfindungsgemäßen Profilschienen erzielt.

Vorteilhaft sind die Öffnungen im Wesentlichen rechteckig oder trapezförmig ausgebildet. Durch diese Form der Öffnungen ist zum einen eine gerade Außenkante der aus den Öffnungen heraus geklappten Materialabschnitte gewährleistet. Zum anderen ist ein möglichst gleichmäßiger Aufbau des Untergurts möglich.

Nach einer weiteren bevorzugten Ausführungsform der Erfindung besitzen die beiden Untergurtabschnitte im Wesentlichen die gleiche Breite. Dadurch ist gewährleistet, dass die Auflageflächen für die Deckenplatten beiderseits des Steges jeweils im Wesentlichen die gleiche Breite bzw. Tiefe besitzen.

Bevorzugt stehen der Untergurt und der Steg im Wesentlichen senkrecht aufeinander, so dass ein optimales T-Profil gebildet wird.

Nach einer weiteren vorteilhaften Ausführungsform der Erfindung ist der Radius der Abwinklung kleiner als 3 mm, insbesondere kleiner als 2 mm, bevorzugt kleiner als 1 mm. Je scharfkantiger die Abwinklung ausgebildet wird, desto höher ist die Welligkeit im Bereich des Untergurts und damit im Bereich der Sichtblende, so dass ein leichter Biegeradius bevorzugt ist. Der Biegeradius darf jedoch nicht zu groß sein, da andernfalls die Auflagefläche für die Deckplatten zu klein wird. Die Biegung kann beispielsweise durch Walzprofilieren oder Kanten erfolgen.

Bevorzugt ist der Grundkörper aus einem einheitlichen Materialstreifen, insbesondere aus einem Metall- oder Blechstreifen hergestellt. Auf diese Weise brauchen keine Einzelteile miteinander verbunden zu werden, so dass ein zusätzlicher Verarbeitungsschritt entfallen kann. Der Steg und/oder der Untergurt sind dabei im Wesentlichen flach ausgebildet, um zum einen eine gute Auflagefläche für die Platten und zum anderen eine gute Stapelbarkeit bei der Lagerung zu gewährleisten.

Die Dicke des Steges und/oder des Untergurtes kann ca. zwischen 0,1 und 0,5 mm, bevorzugt zwischen 0,2 und 1 mm, insbesondere ca. zwischen 0,3 und 0,8 mm betragen. Mit diesen Maßen wird ein optimaler Kompromiss zwischen erforderlicher Steifigkeit und Kosten erzielt.

Nach einer weiteren bevorzugten Ausführungsform ist die Sichtblende auf den Untergurt aufgewalzt. Grundsätzlich ist auch jede sonstige Anbringung, beispielsweise eine Verklebung, denkbar. Die Sichtfläche der Sichtblende ist bevorzugt beschichtet, um damit eine ansprechende Oberfläche zu erzeugen. Weiterhin werden die außen liegenden Längskanten des Untergurts bevorzugt durch die Sichtblende umfasst, wodurch zum einen ein sauberer seitlicher Abschluss des Untergurts erzeugt wird und zum anderen die Stabilität der T-Profilschiene weiter erhöht wird.

Nach einer weiteren vorteilhaften Ausführungsform der Erfindung ist an der dem Untergurt gegenüberliegenden Längskante des Steges ein Obergurt vorgesehen. Dieser Obergurt kann in bekannter Weise, beispielsweise als Hohlprofil, ausgebildet sein. Der Obergurt kann jedoch auch in sonstiger Weise, beispielsweise auch ähnlich oder identisch dem Untergurt durch eine erfindungsgemäße Faltung, beispielsweise entsprechend dem Anspruch 26 gebildet sein.

Durch einen Obergurt kann zum einen die Steifigkeit des Profils erhöht werden, und zum anderen kann der Obergurt zum Ankoppeln von Befestigungselementen an die Profilschiene, insbesondere von Aufhängeelementen ausgebildet sein. Grundsätzlich ist es auch möglich, dass in dem Steg zusätzliche Befestigungsöffnungen für Befestigungselemente, insbesondere Aufhängeelemente, ausgebildet sind. Während durch einen entsprechend ausgebildeten Obergurt die Befestigungselemente im Wesentlichen kontinuierlich über die gesamte Länge der Profilschiene angebracht werden können, ist im Falle von Befestigungsöffnungen lediglich eine Anbringung der Befestigungselemente in diskreten Abständen möglich. Sind zusätzliche Befestigungsöffnungen innerhalb des Stegs vorgesehen, so können die Befestigungselemente beispielsweise kostengünstig als Abhängedrähte ausgebildet sein.

Vorteilhaft kann der Obergurt eine Längskante umfassen, die mit dem Steg, insbesondere mit der Oberkante des Steges verbunden ist. Durch diese Verbindung, die sich insbesondere über die gesamte Länge oder über Teilbereich des Steges erstrecken kann, wird die Stabilität der Profilschiene erhöht. Die Verbindung kann dabei bevorzugt durch Stitching oder durch ein sonstiges geeignetes Verfahren wie Vernieten oder Verkleben erfolgen. Dabei können eine oder mehrer Stitchingnähte vorgesehen sein. Weiterhin können die Nähte parallel zueinander und/oder zur Längeausdehnung des Steges oder bereichsweise schräg dazu, beispielsweise in Form eines Zick-Zack-Musters oder eines Fischgrätenmusters verlaufen. Auch wenn die Längskante des Obergurtes bereichsweise mit dem Steg entlang der Verbindungsfläche überlappt, so ist der Steg selbst weiterhin im Wesentlichen über seine gesamte Fläche einlagig ausgebildet, da die überlappende Fläche des Obergurts keinen Teil des Steges im Sinne dieser Anmeldung bildet.

Bevorzugt besitzen die Öffnungen in Längsrichtung des Steges im Wesentlichen die gleiche Breite. Insbesondere ist die Breite der Öffnungen in Längsrichtung des Steges im Wesentlichen gleich der Breite der in Längsrichtung des Steges zwischen den Öffnungen liegenden Materialabschnitte des Steges. Dadurch wird eine optimierte Belastungsaufnahme der Profilschiene erreicht.

Nach einer weiteren vorteilhaften Ausführungsform der Erfindung sind in und/oder an dem Stegmaterial Verstärkungselemente, insbesondere Verstärkungssicken ausgebildet. Bevorzugt sind dabei die Verstärkungselemente in und/oder an den zwischen den Öffnungen liegenden Materialabschnitten des Steges ausgebildet. Durch die Verstärkungselemente wird die Stabilität einer erfindungsgemäß ausgebildeten Profilschiene erhöht. Vorteilhaft sind in und/oder an zumindest einem Teil der zwischen zwei Öffnungen liegenden Materialabschnitte jeweils mindestens zwei Verstärkungselemente ausgebildet, die sich ausgehend von dem Materialabschnitt in entgegengesetzte Richtungen nach außen erstrecken. So können beispielsweise Verstärkungssicken vorgesehen sein, von denen eine oder mehrere durch Einprägung in die eine Seite und eine oder mehrere weitere durch Einprägung in die andere Seite des Stegmaterials erzeugt werden.

Gemäß dem erfindungsgemäßen Verfahren zum Herstellen einer erfindungsgemäß ausgebildeten Profilschiene wird ein lang gestreckter Materialstreifen, insbesondere ein Metall- oder Blechstreifen, mit einer Vielzahl von länglichen Einschnitten versehen, wobei die beiden freien Enden der Einschnitte jeweils auf einer im Wesentlichen parallel zur Längsachse des Materialstreifens verlaufenden, eine Biegelinie bildenden Geraden angeordnet sind und der Materialstreifen entlang dieser Biegelinie umgebogen wird.

Durch den Biegevorgang klappen die von den Schnittlinien umrandeten Materialabschnitte des Stegs aus diesem heraus und bilden damit eine Hälfte des Untergurts der Profilschiene (im folgenden Untergurtabschnitt genannt), wobei dieser Untergurtabschnitt aus einer Vielzahl von in Längsrichtung voneinander beabstandeten Materialabschnitten besteht.

Der gleichzeitig durch den Biegevorgang in die entgegengesetzte Richtung gebogene Teil des Stegs bildet den zweiten Untergurtabschnitt, welcher über seine gesamte Länge einstückig ausgebildet ist. Grundsätzlich können, wie weiter oben beschrieben, die beiden Untergurtabschnitte auch über Teilbereiche des Materialabschnitts jeweils abwechselnd durch die heraus geklappten Materialabschnitte bzw. den gegenüberliegenden umgebogenen Teil des Materialabschnitts gebildet werden.

Durch das erfindungsgemäße Verfahren werden somit in einem einzigen Biegevorgang und damit in einem einzigen Arbeitsschritt der Steg und der Untergurt in seiner endgültigen Form ausgebildet. Gleichzeitig werden in dem Steg Öffnungen gebildet, welche als Sollknickstellen für den Brandfall dienen.

Bevorzugt wird der Materialstreifen um ca. 90° umgebogen, um auf diese Weise ein T-Profil zu erzeugen.

Die Einschnitte können durch ein Rotations- oder Laserschneidverfahren, durch einen Stanzvorgang oder auch durch ein sonstiges geeignetes Verfahren erzeugt werden.

Nach einer vorteilhaften Ausführungsform der Erfindung sind die Einschnitte U-förmig, insbesondere mit einer geradlinigen Basis und bevorzugt senkrecht dazu verlaufenden geraden Schenkeln, oder trapezförmig ausgebildet. Die Höhe der Einschnitte, d. h. jeweils der senkrechte Abstand von der Biegelinie zu dem entferntest gelegenen Punkt des jeweiligen Einschnittes, sind bevorzugt im Wesentlichen gleich groß. Dadurch ist gewährleistet, dass alle heraus geklappten Materialabschnitte die gleiche Höhe besitzen und damit der aus diesen Materialabschnitten gebildete Untergurtabschnitt, bis auf die zwischen den Materialabschnitten liegenden materialfreien Bereiche, eine einheitliche Breite besitzt.

Weiterhin ist die Höhe der Einschnitte bevorzugt im Wesentlichen gleich dem Abstand zwischen der Biegelinie und der Längskante des Materialstreifens, so dass die beiden den Untergurt bildenden Untergurtabschnitte im Wesentlichen gleich breit und symmetrisch bezüglich des Stegs angeordnet sind.

Weitere vorteilhafte Ausführungsformen der Erfindung sind in den Unteransprüchen angegeben.

Die Erfindung wird nachfolgend anhand von Ausführungsbeispielen unter Bezugnahme auf die Zeichnungen näher-beschrieben; in diesen zeigen:
- Fig. 1: eine perspektivische Ansicht einer Rahmenkonstruktion mit T-Profilschienen gemäß dem Stand der Technik zur Bildung einer Rasterdecke,
- Fig. 2: eine Draufsicht auf einen Blechstreifen mit erfindungsgemäß ausgebildeten Schnittlinien,
- Fig. 3: eine perspektivische Ansicht einer erfindungsgemäß ausgebildeten Profilschiene gemäß einem Zwischenschritt des Herstellungsverfahrens,
- Fig. 4: einen Querschnitt durch die Profilschiene nach Fig. 3,
- Fig. 5: die Ansicht nach Fig. 4 mit zusätzlicher Sichtblende,
- Fig. 6: die Ansicht nach Fig. 3 mit zugehöriger Sichtblende,
- Fig. 7 - 9: weitere Ausführungsformen der Erfindung im Querschnitt,
- Fig. 10: einen Querschnitt durch eine Profilschiene gemäß Fig. 1,
- Fig. 11: eine weitere Ausführungsformen der Erfindung im Querschnitt und
- Fig. 12: eine perspektivische Darstellung der Profilschiene aus Fig. 7.

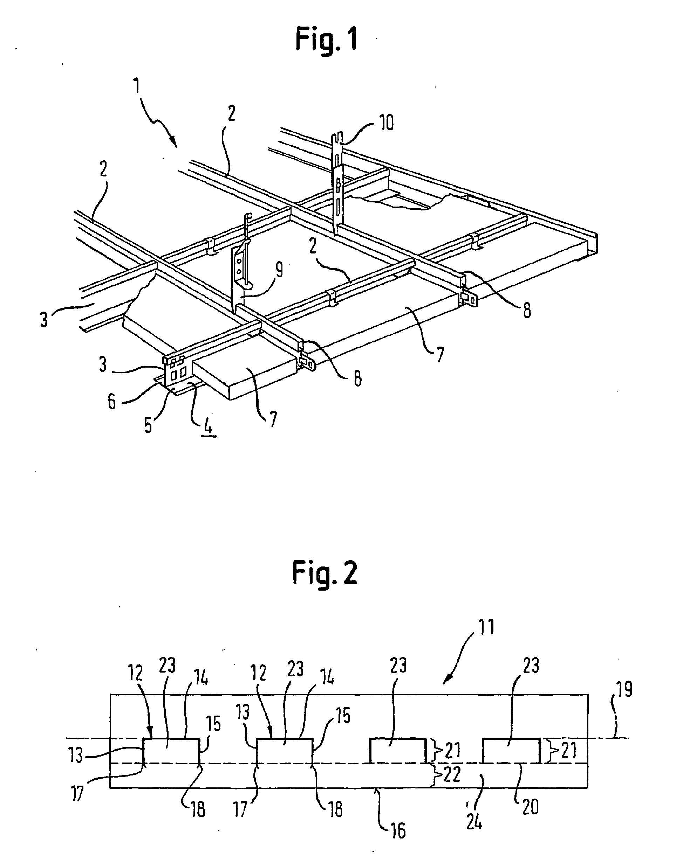

Fig. 1 zeigt eine Rahmenkonstruktion 1, die aus einer Vielzahl von parallelen und senkrecht dazu verlaufenden Profilschienen 2 besteht.

Die Profilschienen 2 besitzen einen T-förmigen Querschnitt, mit einem lang gestreckten Steg 3 sowie einem sich an seiner unteren Längskante anschließenden Untergurt 4. Der Untergurt 4 besteht aus zwei Umbiegungen des Stegs 3 jeweils nach außen, durch die zwei Untergurtabschnitte 5, 6 gebildet werden, die Auflageflächen für plattenförmige Elemente 7, beispielsweise Deckenplatten bilden.

Die Profilschienen 2 besitzen an ihrer oberen Längsseite einen Obergurt 8, der als Hohlprofil ausgebildet ist und zur Ankopplung der Profilschienen 2 an Abhängeelemente 9, 10 dient.

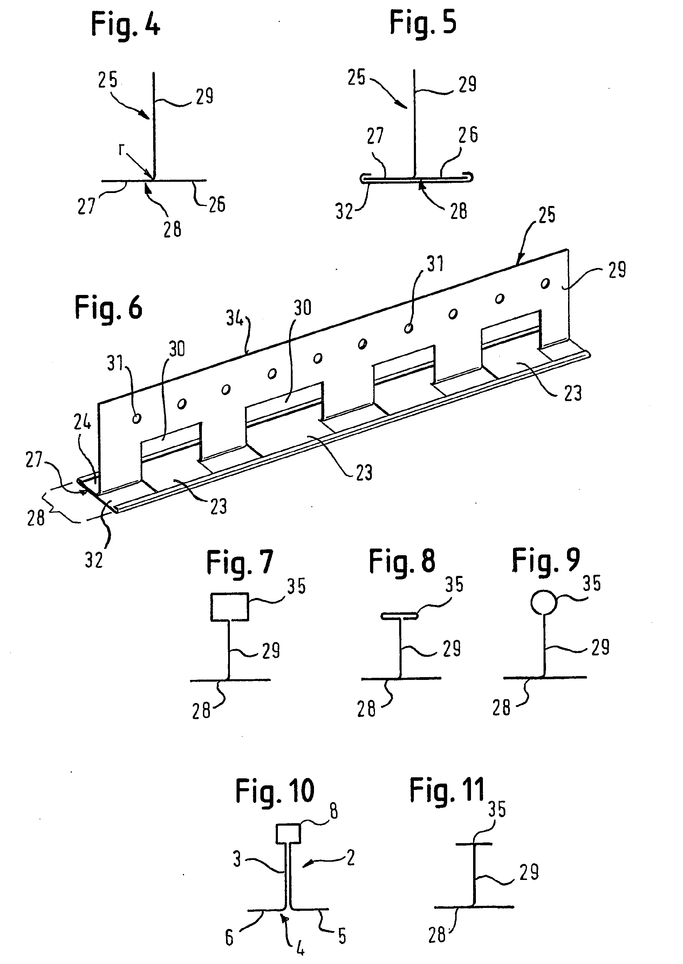

Aus dem Querschnitt nach Fig. 10 durch eine der Profilschienen 2 ist ersichtlich, dass die Profilschiene 2 einen symmetrischen Aufbau besitzt. Nachteilig daran ist, dass der Steg 3 doppellagig ausgebildet ist, wodurch ein hoher Materialverbrauch gegeben ist.

Fig. 2 zeigt eine Draufsicht auf einen Blechstreifen 11, wie er den Ausgangspunkt für die Herstellung einer erfindungsgemäß ausgebildeten Profilschiene bildet.

In dem Blechstreifen 11 ist eine Vielzahl von länglichen, U-förmig ausgebildeten Einschnitten 12 vorgesehen, die jeweils aus drei geradlinigen Teileinschnitten 13, 14, 15 bestehen, welche senkrecht aufeinander stehen. Die Teileinschnitte 14 verlaufen dabei parallel zu einer der Längskanten 16 des Blechstreifens 11.

Die freien Enden 17, 18 der Einschnitte 12 liegen jeweils auf einer parallel zur Längsachse 19 des Blechstreifens 11 verlaufenden, eine Biegelinie 20 bildenden Gerade.

Die Höhe 21 der Einschnitte 12 sind im Wesentlichen gleich groß und im Wesentlichen gleich dem Abstand 22 zwischen der Biegelinie 20 und der Längskante 16 des Blechstreifens 11. Weiterhin sind die U-förmigen Einschnitte 12 im Wesentlichen gleich breit und besitzen jeweils die gleiche Breite wie die zwischen den Einschnitten 12 liegenden Materialabschnitte 36.

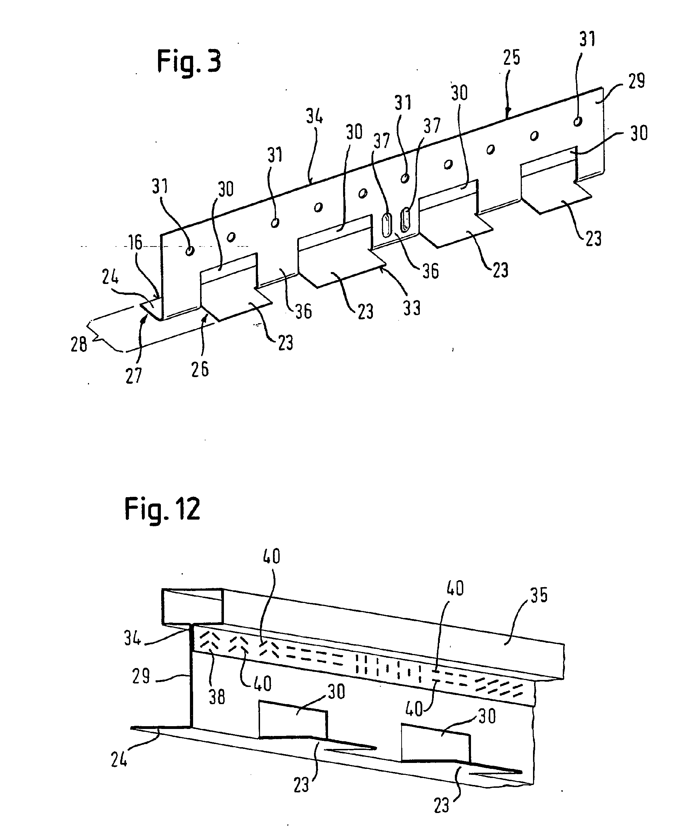

Zur Bildung der erfindungsgemäß ausgebildeten Profilschiene wird der Blechstreifen 11 entlang der Biegelinie 20 so umgefaltet, dass die von den Einschnitten 12 umrahmten Materialabschnitte 23 des Blechstreifens 11 aus der Zeichnungsebene heraus und der zwischen der Biegelinie 20 und der Längskante 16 angeordnete streifenförmige Abschnitt 24 in die Zeichnungsebene hinein geklappt wird, so dass der in Fig. 3 dargestellte Grundkörper 25 der Profilschiene entsteht.

Wie Fig. 3 zu entnehmen ist, bilden nach dem Klappvorgang der streifenförmige Abschnitt 24 sowie die Materialabschnitte 23 Untergurtabschnitte 26, 27 eines Untergurts 28, während der restliche Bereich des Blechstreifens 11, der im Wesentlichen senkrecht auf dem Untergurt 28 steht, einen Steg 29 des Grundkörpers 25 bildet. Die Biegelinie 20 bildet dabei die untere Längskante des Steges 29, an den sich der Untergurt 28 anschließt.

Durch das Herausklappen der Materialabschnitte 23 entstehen in dem Steg 29 Öffnungen 30, die im Wesentlichen rechteckförmig ausgebildet sind.

Weiterhin sind in Fig. 3 in dem Steg 29 zusätzliche Befestigungsöffnungen 31 in Form von Bohrungen vorgesehen, die sich in regelmäßigen Abständen wiederholen. Zusätzlich sind in den Materialabschnitten 36 zwischen den Öffnungen 30 jeweils zwei Verstärkungssicken 37 ausgebildet, die durch in entgegengesetzte Richtungen weisende Einprägungen in der Oberfläche des Steges 29 ausgebildet sind, so dass die eine Verstärkungssicke aus der Zeichnungsebene heraus- und die andere in diese hineinragt. Während in Fig. 3 nur in einem Materialabschnitt 36 Verstärkungssicken 37 gezeigt sind, können diese auch in den übrigen Materialabschnitten 36 oder in einem sonstigen Bereich des Steges 29 und/oder des Untergurts 28 ausgebildet sein.

Um eine beim Faltvorgang entstehende Welligkeit des Untergurts 28 möglichst zu vermeiden, wird entlang der Biegelinie 20 ein geringer Biegeradius r eingehalten; der insbesondere aus dem Querschnitt nach Fig. 4 zu erkennen ist. Zur vollständigen Herstellung einer erfindungsgemäß ausgebildeten Profilschiene wird die Unterseite des Untergurts 28 mit einer Sichtblende 32 versehen, wie es aus den Fig. 5 und 6 erkennbar ist. Die Sichtblende 32 ist üblicherweise zumindest an der Unterseite beschichtet und umfasst die außen liegenden Lärigskanten 16, 33 des Untergurts 20, so dass eine zusätzliche Stabilisierung des Untergurts 28 erreicht wird.

Die Öffnungen 30 dienen gleichzeitig als Soll-Knickstellen für die erfindungsgemäß ausgebildete Profilschiene beispielsweise im Brandfall. Erfolgt im Brandfall aufgrund der großen Hitze eine starke Längsausdehnung der Profilschienen, so knicken die Profilschienen aufgrund der Materialschwächungen durch die Öffnungen 30 ein, bevor aufgrund der Längsausdehnung die Befestigungselemente, mit denen die Profilschiene an der Decke abgehängt ist, ausreißen, so dass ein Herabstürzen der gesamten Deckenkonstruktion verhindert wird.

Befestigungselemente zum Abhängen an einer Decke können bei dem Ausführungsbeispiel nach Fig. 6 beispielsweise in die Befestigungsöffnungen 31 eingehängt werden. Die Befestigungselemente können dabei beispielsweise als einfache Befestigungsdrähte mit einem U-förmigen Ende ausgebildet sein. Grundsätzlich ist es auch möglich, dass die Befestigung einer erfindungsgemäß ausgebildeten Profilschiene durch einen an der Oberkante 34 des Grundkörpers 25 ausgebildeten Obergurt 35 erfolgt. Der Obergurt 35 kann dabei gemäß dem in Fig. 1 dargestellten Obergurt 8 nach dem Stand der Technik, oder auf sonstige Weise, wie beispielsweise in den Fig. 7 bis 9 oder 11 dargestellt, ausgebildet sein. Gemäß Fig. 11 ist der Obergurt ebenso wie der Untergurt auf eine erfindungsgemäße Weise, z.B. entsprechend den Ansprüchen 19 oder 24, ausgebildet. Da der Obergurt in diesem Fall keine durchgehenden Obergurtabschnitte aufweist, kann er optional mit Eindellungen versehen sein, die mit Aufhängeelementen zusammenwirken und somit eine Verschiebung der Aufhängeelemente in Längsrichtung der Profilschiene verhindern.

Weiterhin kann der Obergurt 35, wie in Fig. 12 gezeigt, eine Längskante 38 aufweisen, die über Stitchingnähte 40 mit der Längskante 34 des Steges 29 verbunden ist. Die Stitchingnähte 40 können dabei unterschiedliche Muster bilden, wie sie beispielhaft in Fig. 12 dargestellt sind. Im Gegensatz zu Fig. 12 könen auch nur eine Stitchingnaht oder eine Vielzahl solcher Stitchingnähte vorgesehen sein. Eine solche oder eine sonstige geeignete Verbindung kann auch bei den übrigen in den Fig. 8, 9 und 11 dargestellten Obergurten oder bei sonstigen Realisierungen von Obergurten vorgesehen sein; um die Steifigkeit einer erfindungsgemäßen Profilschiene zu erhöhen.

### Bezugszeichenliste

- 1: Rahmenkonstruktion
- 2: Profilschiene
- 3: Steg
- 4: Untergurt
- 5: Untergurtabschnitt
- 6: Untergurtabschnitt
- 7: plattenförmige Elemente
- 8: Obergurt
- 9: Abhängelemente
- 10: Abhängelemente
- 11: Blechstreifen
- 12: Einschnitte
- 13: Teileinschnitte
- 14: Teileinschnitte
- 15: Teileinschnitte
- 16: Längskante
- 17: freies Ende der Einschnitte 12
- 18: freies Ende der Einschnitte 12
- 19: Längsachse
- 20: Biegelinie
- 21: Höhe
- 22: Abstand
- 23: Materialabschnitt
- 24: streifenförmiger Abschnitt
- 25: Grundkörper
- 26: Untergurtabschnitt
- 27: Untergurtabschnitt
- 28: Untergurt
- 29: Steg
- 30: Öffnungen
- 31: Befestigungsöffnungen
- 32: Sichtblende
- 33: Längskante
- 34: Längskante
- 35: Obergurt
- 36: Materialabschnitte
- 37: Verstärkungssicken
- 38: Längskante des Obergurts
- 40: Stitchingnähte

## Patentansprüche

1. Profilschiene zum Tragen von plattenförmigen Elementen (7), insbesondere für die Einlegemontage von Deckenplatten für Rasterdecken, mit einem zumindest bereichsweise als T-Profil ausgebildeten Grundkörper (25), der einen lang gestreckten Steg (29) sowie einen Untergurt (28) umfasst, der entlang einer Längskante (20) des Steges (29) angeordnet ist und zwei sich jeweils von dem Steg (29) im Wesentlichen in entgegen gesetzte Richtungen erstreckende Untergurtabschnitte (26, 27) umfasst, wobei der Untergurt (28) durch eine Abwinklung des Steges (29) gebildet und die von dem Steg abgewandt gelegene Seite des Untergurts (28) mit einer Sichtblende (32) versehen ist, Wobei in dem Steg (29) eine Vielzahl von Öffnungen (30) ausgebildet ist
**dadurch gekennzeichnet,**
**dass** zumindest einer der Untergurtabschnitte (26) durch aus den Öffnungen (30) heraus geklappte Materialabschnitte (23) des Steges (29) gebildet ist und dass der Steg (29) im Wesentlichen über seine gesamte Fläche einlagig ausgebildet ist.

2. Profilschiene nach Anspruch 1,
**dadurch gekennzeichnet,**
**dass** einer der Untergurtabschnitte (26) durch eine Vielzahl von aus den Öffnungen (30) heraus geklappte Materialabschnitte (23) des Steges (29) und der andere Untergurtabschnitt (26) im Wesentlichen durch eine einstückige Abwinklung des Steges (29) gebildet ist.

3. Profilschiene nach Anspruch 1,
**dadurch gekennzeichnet,**
**dass** beide Untergurtabschnitte bereichsweise jeweils alternierend durch aus den Öffnungen heraus geklappte Materialabschnitte des Steges und sich daran anschließende einstückige Abwinklungen des Steges gebildet sind, wobei jeweils einem als einstückige Abwinklung ausgebildeten Teilbereich des einen Untergurtabschnitts ein durch die aus den Öffnungen heraus geklappten Materialabschnitte gebildeter Teilbereich des anderen Untergurtabschnittes gegenüberliegt.

4. Profilschiene nach einem der Ansprüche 1 bis 3,
**dadurch gekennzeichnet,**
**dass** die Öffnungen (30) jeweils eine gerade Kante (14) besitzen, die im Wesentlichen parallel zu einer Längskante (16) des Steges (29) verlaufen.

5. Profilschiene nach einem der vorhergehenden Ansprüche,
**dadurch gekennzeichnet,**
**dass** die Öffnungen (30) im Wesentlichen rechteckig oder trapezförmig ausgebildet sind.

6. Profilschiene nach einem der vorhergehenden Ansprüche,
**dadurch gekennzeichnet,**
**dass** die außen liegenden Längskanten (16, 33) der beiden Untergurtabschnitte (26, 27) im Wesentlichen parallel zueinander verlaufen.

7. Profilschiene nach einem der vorhergehenden Ansprüche,
**dadurch gekennzeichnet,**
**dass** die beiden Untergurtabschnitte (26, 27) im Wesentlichen die gleiche Breite besitzen.

8. Profilschiene nach einem der vorhergehenden Ansprüche,
**dadurch gekenzeichnet,**
**dass** der Untergurt (28) und der Steg (29) im Wesentlichen senkrecht aufeinander stehen.

9. Profilschiene nach einem der vorhergehenden Ansprüche,
**dadurch gekennzeichnet,**
**dass** der Radius (r) der Abwinklung kleiner als 3 mm, insbesondere kleiner als 2 mm, bevorzugt kleiner als 1 mm ist.

10. Profilschiene nach einem der vorhergehenden Ansprüche,
**dadurch gekennzeichnet,**
**dass** der Grundkörper (25) aus einem einheitlichen Materialstreifen, insbesondere aus einem Metall- oder Blechstreifen (11) hergestellt ist.

11. Profilschiene nach einem der vorhergehenden Ansprüche,
**dadurch gekennzeichnet,**
**dass** der Steg (29) im Wesentlichen flach ausgebildet ist.

12. Profilschiene nach einem der vorhergehenden Ansprüche,
**dadurch gekennzeichnet,**
**dass** die Dicke des Steges (29) und/oder des Untergurtes (28) ca. zwischen 0,1 und 1,5 mm, bevorzugt ca. zwischen 0,2 und 1 mm, insbesondere ca. zwischen 0,3 und 0,8 mm beträgt.

13. Profilschiene nach einem der vorhergehenden Ansprüche,
**dadurch gekennzeichnet,**
**dass** die Sichtblende (32) auf den Untergurt (28) aufgewalzt oder mit diesem verklebt ist und/oder, an seiner Sichtfläche beschichtet ist und/oder die außen liegenden Längskanten (16, 33) des Untergurts (28) umfasst.

14. Profilschiene nach einem der vorhergehenden Ansprüche, durch **gekennzeichnet**,
**dass** an der dem Untergurt (28) gegenüberliegenden Längskante (34) des Steges ein Obergurt (35) vorgesehen ist.

15. Profilschiene nach Anspruch 14,
**dadurch gekennzeichnet,**
**dass** der Obergurt (35) zum Ankoppeln von Befestigungselementen (9, 10) an die Profilschiene, insbesondere von Aufhängelementen ausgebildet ist.

16. Profilschiene nach Anspruch 14 oder 15,
**dadurch gekennzeichnet,**
**dass** der Obergurt (35) als Hohlprofil ausgebildet ist.

17. Profilschiene nach Anspruch 14 oder 15,
**dadurch gekennzeichnet,**
**dass** der Obergurt (35) entsprechend dem Untergurt (28) hergestellt ist.

18. Profilschiene nach einem der Ansprüche 14 bis 17,
**dadurch gekennzeichnet,**
**dass** der Obergurt (35) eine Längskante (38) umfasst, die mit dem Steg (29), insbesondere mit der Längskante (34) des Steges (29) verbunden ist.

19. Profilschiene nach Anspruche 18,
**dadurch gekennzeichnet,**
**dass** die Längskante (38) des Obergurts (35) mit dem Steg (29) durch Stitching verbunden ist.

20. Profilschiene nach einem der vorhergehenden Ansprüche,
**dadurch gekennzeichnet,**
**dass** in dem Steg (29) zusätzliche Befestigungsöffnungen (31) für Befestigungselemente, insbesondere Aufhängelemente ausgebildet sind.

21. Profilschiene nach einem der vorhergehenden Ansprüche,
**dadurch gekennzeichnet,**
**dass** die Öffnungen (30) in Längsrichtung des Steges (29) im Wesentlichen die gleiche Breite besitzen.

22. Profilschiene nach einem der vorhergehenden Ansprüche,
**dadurch gekennzeichnet,**
**dass** die Breite der Öffnungen (30) in Längsrichtung des Steges (29) im Wesentlichen gleich der Breite der in Längsrichtung des Steges (29) zwischen den Öffnungen (30) liegenden Materialabschnitte (36) des Steges (29) ist.

23. Profilschiene nach einem der vorhergehenden Ansprüche,
**dadurch gekennzeichnet,**
**dass** in und/oder an dem Stegmaterial Verstärkungselemente (37), insbesondere Verstärkungssicken ausgebildet sind.

24. Profilschiene nach Anspruch 23,
**dadurch gekennzeichnet ,**
**dass** die Verstärkungselemente (37) in und/oder an den zwischen den Öffnungen (30) liegenden Materialabschnitten (36) des Steges (29) ausgebildet sind.

25. Profilschiene nach Anspruch 23 oder 24,
**dadurch gekennzeichnet,**
**dass** in und/oder an zumindest einem Teil der zwischen zwei Öffnungen (30) liegenden Materialabschnitte (36) jeweils mindestens zwei Verstärkungselemente (37) ausgebildet sind, die sich ausgehend von dem Materialabschnitt (36) in entgegengesetzte Richtungen nach außen erstrecken.

26. Verfahren zum Herstellen einer Profilschiene nach einem der Ansprüche 1 bis 25 zum Tragen von plattenförmigen Elementen (7), insbesondere für die Einlegemontage von Deckenplatten für Rasterdecken,
**dadurch gekennzeichnet,**
**dass** ein lang gestreckter Materialstreifen (11), insbesondere ein Metall- oder Blechstreifen, mit einer Vielzahl von länglichen Einschnitten (12) versehen wird, wobei die beiden freien Enden (17, 18) der Einschnitte (12) jeweils auf einer im Wesentlichen parallel zur Längsachse (19) des Materialstreifens (1) verlaufenden, eine Biegelinie (20) bildenden Geraden angeordnet sind, und dass der Materialstreifen (11) entlang dieser Biegelinie (20) umgebogen wird.

27. Verfahren nach Anspruch 26,
**dadurch gekennzeichnet,**
**dass** die Einschnitte (12) U-förmig, insbesondere mit einer geradlinigen Basis (14) und bevorzugt senkrecht dazu verlaufenden geraden Schenkeln (13, 15), oder trapezförmig ausgebildet sind.

28. Verfahren nach einem der Ansprüche 26 oder 27,
**dadurch gekennzeichnet,**
**dass** die Höhe (21) der Einschnitte (12), d.h. jeweils der senkrechte Abstand von der Biegelinie (20) zu dem entferntest gelegenen Punkt des jeweiligen Einschnittes (12), im Wesentlichen gleich groß ist.

29. Verfahren nach einem der Ansprüche 26 bis 28,
**dadurch gekennzeichnet,**
**dass** die Höhe (21) der Einschnitte (12), d.h. jeweils der senkrechte Abstand von der Biegelinie (20) zu dem entferntest gelegenen Punkt des jeweiligen Einschnittes (12), im Wesentlichen gleich dem Abstand (32) zwischen der Biegelinie (20) und der Längskante (16) des Materialstreifens ist.

30. Verfahren nach einem der Ansprüche 26 bis 29,
**dadurch gekennzeichnet,**
**dass** die Einschnitte (12) jeweils auf derselben Seite der Biegelinie (20) erzeugt werden.

31. Verfahren nach einem der Ansprüche 26 bis 30,
**dadurch gekennzeichnet,**
**dass** der Materialstreifen (11) um ca. 90° umgebogen wird.

32. Verfahren nach einem der Ansprüche 26 bis 31,
**dadurch gekennzeichnet,**
**dass** die Einschnitte (12) durch ein Rotations- oder Laserschneidverfahren oder durch einen Stanzvorgang erzeugt werden.

## Claims

1. A sectional rail for the support of plate-like elements (7), in particular for the insertion assembly of ceiling panels for grid ceilings, having a base body (25) which is formed at least regionally as a T section and which includes an elongate web (29) as well as a bottom chord (28) which is arranged along a longitudinal edge (20) of the web (29) and includes two bottom chord sections (26, 27) which each extend from the web (29) substantially in opposite directions, with the bottom chord (28) being formed by a bent-over portion of the web (29) and the side of the bottom chord (28) disposed remote from the web being provided with a screening strip (32), wherein a plurality of apertures (30) is formed in the web (29)
**characterized in that**
at least one of the bottom chord sections (26) is formed by material sections (23) of the web (29) folded out of the apertures (30); and **in that** the web (29) is essentially made in one layer over its total area.

2. A sectional rail in accordance with claim 1, **characterized in that** one of the bottom chord sections (26) is formed by a plurality of material sections (23) of the web (29) folded out of the apertures (30) and the other bottom chord section (26) is substantially formed by a one-piece bent-over portion of the web (29).

3. A sectional rail in accordance with claim 1, **characterized in that** both bottom chord sections are respectively alternatingly formed regionally by material sections of the web folded out of the apertures and by one-piece bent-over portions of the web adjoining them, with each part region of the one bottom chord section formed as a one-piece bent-over portion being disposed opposite to a part region of the other bottom chord section formed by material sections folded out of the apertures.

4. A sectional rail in accordance with any one of the claims 1 to 3, **characterized in that** the apertures (30) each have a straight edge (14) extending substantially parallel to a longitudinal edge (16) of the web (29).

5. A sectional rail in accordance with any one of the preceding claims, **characterized in that** the apertures (30) are substantially made in rectangular or trapezoidal form.

6. A sectional rail in accordance with any one of the preceding claims, **characterized in that** the outwardly disposed longitudinal edges (16, 33) of the two bottom chord sections (26, 27) extend substantially parallel to one another.

7. A sectional rail in accordance with any one of the preceding claims, **characterized in that** the two bottom chord sections (26, 27) have substantially the same width.

8. A sectional rail in accordance with any one of the preceding claims, **characterized in that** the bottom chord (28) and the web (29) are substantially perpendicular to one another.

9. A sectional rail in accordance with any one of the preceding claims, **characterized in that** the radius (r) of the bent-over portion is less than 3 mm, in particular less than 2 mm, preferably less than 1 mm.

10. A sectional rail in accordance with any one of the preceding claims, **characterized in that** the base body (25) is produced from a uniform strip of material, in particular from a strip of metal or from a strip of sheet metal (11).

11. A sectional rail in accordance with any one of the preceding claims, **characterized in that** the web (29) is substantially flat.

12. A sectional rail in accordance with any one of the preceding claims, **characterized in that** the thickness of the web (29) and/or of the bottom chord (28) amounts to approximately between 0.1 and 1.5 mm, preferably approximately between 0.2 and 1 mm, in particular approximately between 0.3 and 0.8 mm.

13. A sectional rail in accordance with any one of the preceding claims, **characterized in that** the screening strip (32) is rolled onto the bottom chord (28) or is adhesively bonded to it and/or is laminated at its visible surface and/or encompasses the outwardly disposed longitudinal edges (16, 33) of the bottom chord (28).

14. A sectional rail in accordance with any one of the preceding claims, **characterized in that** a top chord (35) is provided at the longitudinal edge (34) of the web disposed opposite the bottom chord (28).

15. A sectional rail in accordance with claim 14, **characterized in that** the top chord (35) is made for the coupling of fastening elements (9, 10), in particular of suspension elements, to the sectional rail.

16. A sectional rail in accordance with claim 14 or claim 15, **characterized in that** the top chord (35) is made as a hollow section.

17. A sectional rail in accordance with claim 14 or claim 15, **characterized in that** the top chord (35) is made in corresponding manner to the bottom chord (28).

18. A sectional rail in accordance with any one of the claims 14 to 17, **characterized in that** the top chord (35) includes a longitudinal edge (38) which is connected to the web (29), in particular to the longitudinal edge (34) of the web (29).

19. A sectional rail in accordance with claim 18, **characterized in that** the longitudinal edge (38) of the top chord (35) is connected to the web (29) by stitching.

20. A sectional rail in accordance with any one of the preceding claims, **characterized in that** additional fastening apertures (31) are formed in the web (29) for fastening elements, in particular for suspension elements.

21. A sectional rail in accordance with any one of the preceding claims, **characterized in that** the apertures (30) have substantially the same width in the longitudinal direction of the web (29).

22. A sectional rail in accordance with any one of the preceding claims, **characterized in that** the width of the apertures (30) in the longitudinal direction of the web (29) is substantially the same as the width of the material sections (36) of the web (29) disposed in the longitudinal direction of the web (29) between the apertures (30).

23. A sectional rail in accordance with any one of the preceding claims, **characterized in that** reinforcement elements (37), in particular reinforcement beads, are made in and/or at the web material.

24. A sectional rail in accordance with claim 23, **characterized in that** the reinforcement elements (37) are made in and/or at the material sections (36) of the web (29) disposed between the apertures (30).

25. A sectional rail in accordance with claim 23 or claim 24, **characterized in that** at least two reinforcement elements (37) are each formed in and/or at at least some of the material sections (36) disposed between two apertures (30) and extend outwardly in opposite directions, starting from the material section (36).

26. A method for the manufacture of a sectional rail in accordance with any one of the claims 1 to 25 for the support of panel-like elements (7), in particular for the insertion assembly of ceiling panels for grid ceilings,
**characterized in that**
an elongate strip of material (11), in particular a strip of metal or a strip of sheet metal, is provided with a plurality of elongate incisions (12), with the two free ends (17, 18) of the incisions (12) each being arranged on a straight line extending substantially parallel to the longitudinal axis (19) of the strip of material (11) and forming a bending line (20); and **in that** the strip of material (11) is bent over along this bending line (20).

27. A method in accordance with claim 26 , **characterized in that** the incisions (12) are made in U shape, in particular with a straight-line base (14) and straight limbs (13, 15) preferably extending perpendicular thereto, or in trapezoidal form.

28. A method in accordance with one of claims 26 or 27, **characterized in that** the height (21) of the incisions (12), i.e. in each case the perpendicular spacing from the bending line (20) to the point of the respective incision (12) disposed furthest away, are substantially of the same size.

29. A method in accordance with one of claims 26 to 28, **characterized in that** the height (21) of the incisions (12), i.e. in each case the perpendicular spacing from the bending line (20) to the point of the respective incision (12) disposed furthest away, is substantially the same as the spacing (32) between the bending line (20) and the longitudinal edge (16) of the strip of material.

30. A method in accordance with any one of the claims 26 to 29, **characterized in that** the incisions (12) are each produced on the same side of the bending line (20).

31. A method in accordance with any one of the claims 26 to 30, **characterized in that** the strip of material (11) is bent over by approximately 90°.

32. A method in accordance with any one of the claims 26 to 31, **characterized in that** the incisions (12) are produced by a rotation cutting method or by a laser cutting method or by a stamping procedure.

## Revendications

1. Rail profilé pour porter des éléments (7) en forme de plaque, en particulier pour le montage par insertion de plaques de plafond pour plafonds à trame, comportant un corps de base (25) réalisé au moins localement sous forme de profil en T et présentant une barrette allongée (29) ainsi qu'une membrure inférieure (28) qui est agencée le long d'une arête longitudinale (20) de la barrette (29) et qui comprend deux portions de membrure inférieure (26, 27) s'étendant chacune depuis la barrette (29) sensiblement en sens opposés, la membrure inférieure (28) étant formée par un coudage de la barrette (29) et le côté de la membrure inférieure (28) détourné de la barrette étant pourvu d'un cache (32), une multitude d'ouvertures (30) étant ménagées dans la barrette (29),
**caractérisé en ce que** l'une au moins des portions de membrure inférieure (26) est formée par des portions de matériau (23) de la barrette (29) rabattues hors des ouvertures (30), et **en ce que** la barrette (29) est réalisée monocouche sensiblement sur toute sa surface.

2. Rail profilé selon la revendication 1,
**caractérisé en ce que**
l'une des portions de membrure inférieure (26) est formée par une multitude de portions de matériau (23) de la barrette (29) rabattues hors des ouvertures (30), et l'autre portion de membrure inférieure (26) est formée sensiblement par un coudage monobloc de la barrette (29).

3. Rail profilé selon la revendication 1,
**caractérisé en ce que**
les deux portions de membrure inférieure sont formées localement par une alternance respective de portions de matériau de la barrette rabattues hors des ouvertures et de coudages monoblocs de barrette qui s'y raccordent, une zone partielle respective, réalisée sous forme de coudage monobloc, de l'une des portions de membrure inférieure étant en regard d'une zone partielle, formée par les portions de matériau rabattues hors des ouvertures, de l'autre portion de membrure inférieure.

4. Rail profilé selon l'une des revendications 1 à 3,
**caractérisé en ce que**
les ouvertures (30) possèdent chacune une arête rectiligne (14) qui s'étend sensiblement parallèlement à une arête longitudinale (16) de la barrette (29).

5. Rail profilé selon l'une des revendications précédentes,
**caractérisé en ce que**
les ouvertures (30) sont réalisées sensiblement en forme rectangulaire ou trapézoïdale.

6. Rail profilé selon l'une des revendications précédentes,
**caractérisé en ce que**
les arêtes longitudinales extérieures (16, 33) des deux portions de membrure inférieure (26, 27) s'étendent sensiblement parallèlement l'une à l'autre.

7. Rail profilé selon l'une des revendications précédentes,
**caractérisé en ce que**
les deux portions de membrure inférieure (26, 27) possèdent sensiblement la même largeur.

8. Rail profilé selon l'une des revendications précédentes,
**caractérisé en ce que**
la membrure inférieure (28) et la barrette (29) sont dressées sensiblement perpendiculairement l'une à l'autre.

9. Rail profilé selon l'une des revendications précédentes,
**caractérisé en ce que**
le rayon (r) du coudage est inférieur à 3 mm, en particulier inférieur à 2 mm, de préférence inférieur à 1 mm.

10. Rail profilé selon l'une des revendications précédentes,
**caractérisé en ce que**
le corps de base (25) est réalisé à partir d'une bande de matériau unitaire, en particulier à partir d'une bande de métal ou de tôle (11).

11. Rail profilé selon l'une des revendications précédentes,
**caractérisé en ce que**
la barrette (29) est réalisée sensiblement plate.

12. Rail profilé selon l'une des revendications précédentes,
**caractérisé en ce que**
l'épaisseur de la barrette (29) et/ou de la membrure inférieure (28) est comprise entre environ 0,1 mm et 1,5 mm, de préférence entre environ 0,2 et 1 mm, en particulier entre environ 0,3 et 0,8 mm.

13. Rail profilé selon l'une des revendications précédentes,
**caractérisé en ce que**
le cache (32) est laminé sur la membrure inférieure (28) ou collé sur celle-ci et/ou revêtu sur son côté visible et/ou comprend les arêtes longitudinales extérieures (16, 33) de la membrure inférieure (28).

14. Rail profilé selon l'une des revendications précédentes,
**caractérisé en ce que**
sur l'arête longitudinale (34), opposée à la membrure inférieure (28), de la barrette est prévue une membrure supérieure (35).

15. Rail profilé selon la revendication 14,
**caractérisé en ce que**
la membrure supérieure (35) est réalisée pour accoupler des éléments de fixation (9, 10) au rail profilé, en particulier des éléments de suspension.

16. Rail profilé selon la revendication 14 ou 15,
**caractérisé en ce que**
la membrure supérieure (35) est réalisée sous forme de profil creux.

17. Rail profilé selon la revendication 14 ou 15,
**caractérisé en ce que**
la membrure supérieure (35) est réalisée en correspondance de la membrure inférieure (28).

18. Rail profilé selon l'une des revendications 14 à 17,
**caractérisé en ce que**
la membrure supérieure (35) comprend une arête longitudinale (38) qui est reliée à la barrette (29), en particulier à l'arête longitudinale (34) de la barrette (29).

19. Rail profilé selon la revendication 18,
**caractérisé en ce que**
l'arête longitudinale (38) de la membrure supérieure (35) est reliée par couture avec la barrette (29).

20. Rail profilé selon l'une des revendications précédentes,
**caractérisé en ce que**
dans la barrette (29) sont ménagées des ouvertures de fixation supplémentaires (31) pour des éléments de fixation, en particulier des éléments de suspension.

21. Rail profilé selon l'une des revendications précédentes,
**caractérisé en ce que**
les ouvertures (30) présentent sensiblement la même largeur en direction longitudinale de la barrette (29).

22. Rail profilé selon l'une des revendications précédentes,
**caractérisé en ce que**
la largeur des ouvertures (30) en direction longitudinale de la barrette (29) est sensiblement égale à la largeur des portions de matériau (36) de la barrette (29) situées entre les ouvertures (30) dans la direction longitudinale de la barrette (29).

23. Rail profilé selon l'une des revendications précédentes,
**caractérisé en ce que**
dans et/ou sur le matériau de barrette sont réalisés des éléments de renforcement (37), en particulier des moulures de renforcement.

24. Rail profilé selon la revendication 23,
**caractérisé en ce que**
les éléments de renforcement (37) sont réalisés dans et/ou sur les portions de matériau (36) de la barrette (29) situées entre les ouvertures (30).

25. Rail profilé selon la revendication 23 ou 24,
**caractérisé en ce que**
dans et/ou sur une partie au moins des portions de matériau (36) situées entre deux ouvertures (30) sont réalisés au moins deux éléments de renforcements (37) respectifs qui s'étendent depuis la portion de matériau (36) vers l'extérieur dans des directions opposées.

26. Procédé pour réaliser un rail profilé selon l'une des revendications 1 à 25 pour porter des éléments (7) en forme de plaque, en particulier pour le montage par insertion de plaques de plafond pour plafonds à trame,
**caractérisé en ce qu'**une bande de matériau allongée (11), en particulier une bande de métal ou de tôle est munie d'une multitude d'entailles oblongues (12), les deux extrémités libres (17, 18) des entailles (12) étant agencées sur une droite s'étendant sensiblement parallèlement à l'axe longitudinal (19) de la bande de matériau (11), en formant une ligne de pliage (20), et **en ce que** la bande de matériau (11) est repliée le long de cette ligne de pliage (20).

27. Procédé selon la revendication 26,
**caractérisé en ce que**
les entailles (12) sont réalisées en forme de U, en particulier avec une base rectiligne (14) et avec des branches rectilignes (13, 15) s'étendant de préférence perpendiculairement à celle-ci, ou elles sont réalisées en forme trapézoïdale.

28. Procédé selon l'une des revendications 26 ou 27,
**caractérisé en ce que**
la hauteur (21) des entailles (12), c'est-à-dire la distance respective verticale de la ligne de pliage (20) par rapport au point de l'entaille respective (12) le plus éloigné est sensiblement identique.

29. Procédé selon l'une des revendications 26 à 28,
**caractérisé en ce que**
la hauteur (21) des entailles (12), c'est-à-dire la distance respective verticale de la ligne de pliage (20) par rapport au point de l'entaille respective (12) le plus éloigné est sensiblement égale à la distance (32) entre la ligne de pliage (20) et l'arête longitudinale (16) de la bande de matériau.

30. Procédé selon l'une des revendications 26 à 29,
**caractérisé en ce que**
les entailles (12) sont réalisées chacune sur le même côté de la ligne de pliage (20).

31. Procédé selon l'une des revendications 26 à 30,
**caractérisé en ce que**
la bande de matériau (11) est repliée d'environ 90°.

32. Procédé selon l'une des revendications 26 à 31,
**caractérisé en ce que**
les entailles (12) sont réalisées par un procédé de coupe au tour ou au laser ou par une opération de poinçonnage.
